Europäisches Patentamt

European Patent Office

Office européen des brevets

(11) Veröffentlichungsnummer: **0 024 614**
B1

# (12) EUROPÄISCHE PATENTSCHRIFT

(45) Veröffentlichungstag der Patentschrift:
21.11.84

(21) Anmeldenummer: 80104725.9

(22) Anmeldetag: 11.08.80

(51) Int. Cl.³: **C 01 B 33/02**, H 01 L 31/18

(54) Verfahren zum Reinigen von Rohsilicium.

(30) Priorität: 16.08.79 DE 2933164

(43) Veröffentlichungstag der Anmeldung:
11.03.81 Patentblatt 81/10

(45) Bekanntmachung des Hinweises auf die Patenterteilung:
21.11.84 Patentblatt 84/47

(84) Benannte Vertragsstaaten:
BE DE FR GB IT NL

(56) Entgegenhaltungen:
DE - A - 2 729 464
FR - A - 1 136 017
FR - A - 1 230 158
GB - A - 874 547
US - A - 2 972 521

EXTENDED ABSTRACTS, The Electrochemical Society, inc. Spring meeting, Band 76-1, 2-7. Mai 1976 Washington, D.C., US L.P. HUNT et al.: "Purification of metallurgical-grade silicon to solar-grade quality", Seite 560, Zusammenfassung Nr. 227
CHEMISCHES ZENTRALBLATT, Jahrgang 138, Nr. 7, 15. Februar 1967, Berlin und Weinheim-Bergstrasse, E. BONNIER et al.: "Darstellungsverfahren für Silicium hoher Reinheit", Seite 66, rechte Spalte Zusammenfassung Nr. 0726

(73) Patentinhaber: Consortium für elektrochemische Industrie GmbH, Zielstattstrasse 20,
D-8000 München 70 (DE)

(72) Erfinder: Dietl, Josef, Dr. Dipl.-Phys, Am Bärenbach 17,
D-8262 Neuötting (DE)
Erfinder: Wohlschläger, Michael, Friedlandstrasse 13,
D-8034 Unterpfaffenhofen (DE)

**Beschreibung**

Gegenstand der Erfindung ist ein Verfahren zum Reinigen von Rohsilicium mit einem Siliciumgehalt von über 95 Gew.-% für die Herstellung von Solarzellen durch Auslaugen mit einer Säurelösung.

Die Erfindung ist in erster Linie vor dem Hintergrund der Energiegewinnung mit Hilfe von Silicium-Solarzellen zu sehen. Um mit derartigen Solarzellen einen wirtschaftlich konkurrenzfähigen Beitrag zur Versorgung mit elektrischer Energie leisten zu können, ist es erforderlich, das Grundmaterial Silicium ausreichend billig zur Verfügung zu stellen. Dieses auf der Erde in Form von $SiO_2$ in praktisch unerschöpflichen Mengen vorhandene Silicium muß aber zunächst reduziert und gereinigt werden. Die Reinigung des Rohsiliciums über die Gasphase, wie sie für die Herstellung von hochwertigen elektronischen Bauelementen üblich ist, scheidet aus, da sie um ein Vielfaches zu teuer ist. An die Reinheit von Solarzellensilicium werden jedoch keine so hohen Anforderungen gestellt, so daß billigere Reinigungsverfahren herangezogen werden können. Ein bekanntes Verfahren zur Reinigung von Rohsilicium besteht beispielsweise in der Behandlung mit Säuren oder Säurekombinationen (vgl. beispielsweise Schweizer Patentschrift 567 435, US-Patentschrift 29 72 521 und L.P. Hunt et al »Purification of Metallurgical Grade Silicon to Solar Grade Quality«, Solar Energy, Proc. Internat. Symposium 1976). Bei diesen Verfahren wurden jedoch nur Reinheitsgrade erzielt, die für die Herstellung von Solarzellen entweder noch nicht ausreichen oder außerordentlich lange Bearbeitungszeiten erfordern.

In der Europäischen Patentanmeldung 2 135 wird ein Verfahren zur Reinigung von Rohsilicium beschrieben, nach welchem Silicium in eine Metallschmelze eingebracht, aus dieser kristallisiert, mit einer Extraktionsschmelze behandelt und anschließend durch Ziehen aus der Schmelze unter Ausnutzung der Segregation nachgereinigt wird. In dieser Patentanmeldung werden einleitend noch zahlreiche weitere Literaturstellen, die sich mit der billigen Reinigung von Rohsilicium befassen, beschrieben.

Mit der Deutschen Offenlegungsschrift 27 29 464 wird schließlich ein Verfahren zum Reinigen von Silicium beschrieben, nach welchem vor dem an sich bekannten chemischen Reinigungsschritt das Silicium aufgeschmolzen und durch langsame Abkühlung wieder zum Erstarren gebracht wird, wobei die Siliciumschmelze gegebenenfalls auch noch mit einer Extrakionsschmelze in Kontakt gebracht werden kann.

Der Erfindung lag die Aufgabe zugrunde, ein Reinigungsverfahren für Rohsilicium zu finden, welches gegenüber dem zitierten Stand der Technik zu erhöhter Reinheit bei vergleichsweise geringen Kosten und akzeptablen Bearbeitungszeiten führt.

Gelöst wird diese Aufgabe durch ein Verfahren zum Reinigen von Rohsilicium mit einem Siliciumgehalt von über 95 Gew.-% für die Herstellung von Solarzellen durch Auslaugen mit einer Säurelösung, welches dadurch gekennzeichnet ist, daß dem an sich bekannten chemischen Reinigungsschritt eine Vakuumausdampfung bei 1500 bis 1700°C unter einem Druck von $10^{-6}$ bis $10^{-4}$ bar vor- oder nachgeschaltet wird.

Silicium zum Zweck der Reinigung einer Vakuumbehandlung auszusetzen, wurde zwar schon von L.P. Hunt et al (Dow Corning Corp. Quart. Report No. 2 ERDA/JPL/954559-76/2 Jan. 1977) versucht, jedoch konnte bei den Arbeiten dieser Autoren nicht der geringste Reinigungseffekt erzielt werden, so daß sie prinzipiell von einer derartigen Verfahrensweise abraten.

Nach dem erfindungsgemäßen Verfahren wird Rohsilicium (metallurgical grade silicon), worunter Silicium mit einem Siliciumgehalt über 95 Gew.-% verstanden werden soll, zweckmäßig zerkleinert und zwar vorzugsweise auf eine Korngröße innerhalb 20 bis 60 µm (Feinstaub unterhalb 20 µm weniger als 5 Gew.-%) und mit einer wäßrigen Säurelösung versetzt.

Als Säuren eignen sich insbesondere wäßrige Salzsäuren und wäßrige Flußsäure allein oder besonders vorteilhaft im Gemisch und zwar günstig in einem molaren Verhältnis von etwa 3 : 1 bis 1 : 2. Die Salzsäure wird zweckmäßig als 5 bis 20vol.-%ige wäßrige Säure und die Flußsäure als 2,5 bis 10vol.-%ige wäßrige Säure eingesetzt, wobei sich bei Gemischen der beiden wäßrigen Säuren, bezogen auf den Wassergehalt des Gemisches, natürlich auch andere Gehalte ergeben können.

Als vorteilhaft hat es sich ergeben, auf etwa 1 kg Rohsilicium etwa 1—10 l Säuremischung zuzugeben. Die Behandlungszeit ist temperaturabhängig und beträgt beispielsweise bei 20°C 4 bis 48 Stunden und verkürzt sich bei 80°C auf Behandlungszeiten von etwa 1 bis 24 Stunden. Während der Behandlung kann gegebenenfalls auch verbrauchte Säure ganz oder partiell abgezogen und durch frische Säure bzw. Gemischkomponente ersetzt werden. Nach dieser Zeit wird die Säure abzentrifugiert und das Pulver säurefrei gewaschen. Nach der bevorzugten Ausführungsform des Verfahrens wird das so vorgereinigte Pulver dann aufgeschmolzen und einer Vakuumausdampfung unterworfen, obwohl prinzipiell auch die Säurebehandlung dem Vakuumprozeß nachgeschaltet sein kann. Die erstgenannte Verfahrensweise ist aber meist günstiger, da das nach der Vakuumbehandlung flüssig anfallende Silicium dann unmittelbar zu Solarzellenplättchen — gegebenenfalls nach zusätzlicher Dotierung — vergossen werden kann.

Das nach der Säurebehandlung anfallende Siliciumpulver wird anschließend unter Schutzgas, beispielsweise Argon, Stickstoff oder deren Gemischen bei Normaldruck oder leicht — bis etwa 0,3 bar — reduziertem Druck aufgeschmolzen. Nachfolgend wird der Druck langsam abgesenkt, da anderenfalls die Siliciumschmelze aufgrund enthaltener Verunreinigungen häufig stark zu gasen beginnt.

Als Tiegelmaterialien eignen sich dabei beispielsweise hochdichter oder imporbeschichteter Graphit, Siliciumcarbid oder Siliciumnitrid. Schmelzhöhen bis ca. 30 cm sind von Vorteil. Wird die Schmelze gerührt, beispielsweise mit Graphitrührern — gegebenenfalls mit Schutzschlacke aus Calciumsilicat/Calciumfluorid beschichtet — oder durch induktives Rühren im Mittelfrequenzgebiet, so lassen sich natürlich auch größere Schmelzhöhen beherrschen.

Die Ausdampfung der Siliciumschmelze erfolgt nach Erreichen eines Unterdruckes von etwa $10^{-6}$ bis $10^{-4}$ bar vorteilhaft über einen Zeitraum von etwa 0,5 bis 2 Stunden.

Das solcherart gereinigte Silicium kann nachfolgend — beispielsweise gemäß dem Verfahren der Deutschen Auslegeschrift 25 08 803 — direkt zu Solarzellengrundmaterial in Form von Scheibchen oder Blöcken vergossen werden.

Eine weitere Reinigung läßt sich erzielen, indem das schmelzflüssige Silicium einer gerichteten Erstarrung unterworfen wird, beispielsweise nach dem bekannten »Czochralski-Verfahren« (vgl. W.R. Runyan »Silicon Semiconductor Technology«, S. 34—39, McGraw-Hill, 1965), bei welchem ein Siliciumstab aus der Schmelze gezogen wird, wobei bei angestrebtem einkristallinem Wachstum ein einkristalliner Impfkristall in die Schmelzoberfläche abgesenkt wird, an welchem unter Drehung auskristallisierendes Silicium stabförmig anwächst. Da für Solarzellenmaterial einkristallines Wachstum aber nicht zwingend erforderlich ist, lassen sich auch höhere Ziehgeschwindigkeiten bis maximal etwa 100 mm/h, vorteilhaft etwa zwischen 50 und 75 mm/h anwenden, die zu einem weiter gereinigten, grobkristallinen Material führen. Die letzten ca. 10 Vol.-% der Schmelze werden dabei zweckmäßig wieder dem Rohsilicium zugeschlagen, da sich in ihnen aufgrund der Segregation die Verunreinigungen anreichern.

Besonders günstig erweist es sich, den gesamten Schmelztiegel nach der Vakuumausdampfung langsam aus der Heizzone abzusenken, da auch in diesem Fall grobkörniges, gerichtet erstarrtes nachgereinigtes Silicium resultiert. Abhängig von der Chargengröße wird hier vorteilhaft mit Absenkgeschwindigkeiten von etwa 20 bis 40 mm/h gearbeitet. Auch bei dieser Verfahrensvariante kommt es zu einer Anreicherung von Verunreinigungen im zuletzt erstarrenden Teil, der deshalb abgetrennt und dem Ausgangsmaterial wieder zugeschlagen oder verworfen wird. Bei der gerichteten Erstarrung durch Absenken des Heiztiegels kann es auch von Vorteil sein, die Säurebehandlung nicht als erste, sondern erst im Anschluß daran nach oder während dem Zermahlen des Siliciums vorzunehmen, da sich die Verunreinigungen bei der gerichteten Erstarrung bereits partiell ausschneiden und somit exponiert dem Säureangriff ausgesetzt sind.

Weist das zu reinigende Rohsilicium einen hohen Borgehalt auf, worunter bei Solarzellengrundmaterial durchaus bereits Borgehalte von größer etwa 10 ppm verstanden werden, so wird vorteilhaft das aufgeschmolzene Silicium zusätzlich mit einer Extraktionsschmelze in Kontakt gebracht. Diese gegebenenfalls erforderliche Behandlung mit Extraktionsschmelze wird zweckmäßig als erster Schritt durchgeführt und das wiedererstarrte Silicium anschließend zerkleinert, mit Säure behandelt, wieder aufgeschmolzen und durch Vakuumausdampfung nachgereinigt. Als Extraktionsschmelzen eignen sich solche, bestehend aus Erdalkalisilikaten, beispielsweise Calcium- oder Magnesiumsilikat, beziehungsweise Erdalkalifluoriden wie beispielsweise Calciumfluorid und Magnesiumfluorid sowie Mischschmelzen, bestehend beispielsweise aus Calciumfluorid und Calciumsilikat, Magnesiumfluorid und Magnesiumsilikat sowie Calciumsilikat und Magnesiumsilikat (vgl. beispielsweise Deutsche Patentschrift 10 22 806 und US-Patentschrift 38 71 872). Besonders gute Ergebnisse lassen sich mit der bevorzugt eingesetzten Mischschmelze aus Calciumfluorid mit 30 bis 70 Gew.-% (bezogen auf Mischschmelze!) Calciumsilikat unter oxydierender Atmosphäre erzielen.

Die Extraktionszeit beträgt günstig etwa 0,5 bis 1 Stunde, die Temperatur etwa 1450 bis 1600° C. Das Mengenverhältnis von Extraktionsschmelze zu Silicium wird zweckmäßig im Bereich 1 : 3 bis 10 : 1 gewählt.

### Beispiel 1

Rohsilicium mit einem Borgehalt von 8 Gew.-ppm wurde mit einem Backenbrecher vorzerkleinert und in einer Schwingmühle zu Pulver mit einer mittleren Korngröße innerhalb 20 bis 60 μm gemahlen. 5 kg des Rohsiliciumpulvers wurden mit einem Säuregemisch, hergestellt aus 5 l 20gew.-%iger wäßriger Salzsäure und 5 l 10gew.-%iger wäßriger Flußsäure, unter Rühren 10 Stunden bei 80° C ausgelaugt. Anschließend wurde das Pulver in einer Waschzentrifuge säurefrei gewaschen und getrocknet. Das Pulver wurde dann in einer induktiv beheizten Vakuumschmelzanlage unter Inertgas von 0,65 bar Argon erschmolzen und die Schmelze auf 1600° C gehalten. Die Schmelze befand sich dabei in einem Graphittiegel mit einem Innendurchmesser von 15 cm, bei einer Schmelzhöhe von 12 cm. Durch langsames Absenken des Druckes während einer Zeit von 30 Minuten wurde ein Vakuum von $5 \cdot 10^{-5}$ bar eingestellt. Die ca. 1 Stunde dauernde Vakuumausdampfung wurde dabei durch Rühren der Schmelze mit einem Graphitrührer gefördert.

Anschließend wurde die Siliciumschmelze unter der Einwirkung eines Temperaturgradienten zu Gußblöcken vergossen, die eine für die Solarzellenanwendung geeignete Kolumnarstruktur aufwiesen. Die Gußblöcke wurden aufgesägt und die Scheibchen zu Solarzellen mit Bor-Grunddotierung verarbeitet. Die Auswirkung des erfindungsgemäßen Reinigungsverfahrens durch Säurebehandlung und anschließenden Vakuumausdampfung läßt sich aus Tabelle 1 entnehmen.

### Beispiel 2

Rohsilicium mit einem Borgehalt von 8 Gew.-ppm wurde wie in Beispiel 1 zerkleinert, gemahlen, mit Säure geätzt und vakuumbehandelt. Anschließend wurde die Siliciumschmelze gerichtet erstarrt durch Absenken des Graphittiegels aus der Heizzone mit einer Geschwindigkeit von 25 mm/h. Das dabei entstehende Kristallgefüge zeigte große, kolumnar angeordnete Körner. Die Reinheit der zuerst erstarrten Hälfte des Siliciums ist in Tabelle 1 aufgeführt. Aus diesem Silicium wurden Scheibchen gesägt und zu Solarzellen mit B-Grunddotierung verarbeitet.

### Tabelle 1

Reinheitsangaben in Gew.-ppm

| Element | Rohsilicium | Beispiel 1 | Beispiel 2 |
|---------|-------------|------------|------------|
| Fe | 3500 | 1,5 | 0,2 |
| Al | 1200 | < 1 | < 0,2 |
| Ca | 1500 | < 1 | < 0,5 |
| Mn | 300 | < 0,5 | < 0,1 |
| Ti | 300 | 0,5 | < 0,1 |
| Cr | 40 | < 1 | < 0,1 |
| Cu | 40 | < 0,5 | < 0,1 |
| B | 8 | 8 | 7 |
| P | 30 | < 1 | < 1 |

### Beispiel 3

5 kg Rohsilicium mit einem Borgehalt von 30 Gew.-ppm wurden zusammen mit einer Extraktionsschmelze technischer Reinheit bestehend aus 4 kg $CaF_2$ + 3 kg CaO + 3 kg $SiO_2$ in einem induktionsbeheizten Graphittiegel aufgeschmolzen und bei Temperaturen zwischen 1450 und 1500°C ca. 30 Minuten im Schmelzkontakt gehalten. Diese Schmelzextraktion fand unter oxydierender Atmosphäre (Luft) statt; (um den Tiegelabbrand zu reduzieren, kann aber auch unter Stickstoff gearbeitet werden). Nach der Extraktionszeit wurde durch Abgießen das Silicium von der Calciumfluorid-Calciumsilikat-Schmelze getrennt und in einer Graphitkokille langsam erstarrt. Die weitere Reinigung erfolgte dann in gleicher Weise wie bei Beispiel 1 mit Säure- und Vakuumbehandlung. Anschließend daran wurde die Siliciumschmelze in Blöcke gegossen, diese in Scheibchen zersägt und hieraus Solarzellen hergestellt. Die erzielte Reinheit bezüglich der ursprünglich enthaltenen Verunreinigungskomponenten ist der Tabelle 2 zu entnehmen.

### Tabelle 2

Reinheitsangaben in Gew.-ppm

| Element | Rohsilicium | Beispiel 3 |
|---------|-------------|------------|
| Fe | 3000 | 1 |
| Al | 1500 | < 1 |
| Ca | 1500 | < 1 |
| Mn | 300 | < 0,5 |
| Ti | 300 | 0,5 |
| Cr | 40 | < 1 |
| Cu | 40 | < 0,5 |
| B | 30 | 8 |
| P | 30 | < 1 |

### Patentansprüche

1. Verfahren zum Reinigen von Rohsilicium mit einem Siliciumgehalt von über 95 Gew.-% für die Herstellung von Solarzellen durch Auslaugen mit einer Säurelösung, dadurch gekennzeichnet, daß dem an sich bekannten chemischen Reinigungsschritt eine Vakuumausdampfung bei 1500 bis 1700°C unter einem Druck von $10^{-6}$ bis $10^{-4}$ bar vor- oder nachgeschaltet wird.

2. Verfahren nach Anspruch 1, dadurch gekennzeichnet, daß das zu reinigende Rohsilicium auf eine Korngröße von 20 bis 60 µm zerkleinert wird.

3. Verfahren nach einem oder mehreren der Ansprüche 1 bis 3, dadurch gekennzeichnet, daß als Säurelösung ein Gemisch aus wäßriger Salzsäure und wäßriger Flußsäure eingesetzt wird.

4. Verfahren nach einem oder mehreren der Ansprüche 1 bis 3, dadurch gekennzeichnet, daß je kg Silicium 1 bis 10 Liter Säurelösung zugesetzt werden.

5. Verfahren nach einem oder mehreren der Ansprüche 1 bis 4, dadurch gekennzeichnet, daß das zu reinigende Rohsilicium zusätzlich einer gerichteten Erstarrung unterworfen wird.

6. Verfahren nach Anspruch 5, dadurch gekennzeichnet, daß die gerichtete Erstarrung durch Absenkung des Schmelztiegels aus der Heizzone mit einer Geschwindigkeit von 20 bis 40 mm pro Stunde erfolgt.

7. Verfahren nach einem oder mehreren der Ansprüche 1 bis 6, dadurch gekennzeichnet; daß Rohsilicium mit hohem Borgehalt anfangs aufgeschmolzen und mit einer Extraktionsschmelze in Kontakt gebracht wird.

8. Verfahren nach Anspruch 7, dadurch gekennzeichnet, daß als Extraktionsschmelze eine Mischschmelze aus Calciumfluorid und Calciumsilikat eingesetzt wird.

## Claims

1. Process for purifying metallurgical-grade silicon having a silicon content of more than 95% by weight for the manufacture of solar cells by leaching with an acid solution, characterised in that vacuum evaporation at 1500 to 1700° C under a pressure of from $10^{-6}$ to $10^{-4}$ bar precedes or follows the chemical purification step known per se.

2. Process according to claim 1, characterised in that the metallurgical-grade silicon to be purified is comminuted to a particle size of 20 to 60 μm.

3. Process according to one or more of claims 1 and 2, characterised in that a mixture of aqueous hydrochloric acid and aqueous hydrofluoric acid is used as the acid solution.

4. Process according to one or more of claims 1 to 3, characterised in that from 1 to 10 litres of acid solution are added per kg of silicon.

5. Process according to one or more of claims 1 to 4, characterised in that the metallurgical-grade silicon to be purified is additionally subjected to directional solidification.

6. Process according to claim 5, characterised in that the directional solidification is carried out by lowering the crucible out of the heating zone at a speed of from 20 to 40 mm per hour.

7. Process according to one or more of claims 1 to 6, characterised in that metallurgical-grade silicon having a high boron content is initially melted down and brought into contact with an extraction melt.

8. Process according to claim 7, characterised in that a mixed melt of calcium fluoride and calcium silicate is used as the extraction melt.

## Revendications

1. Procédé pour purifier par lixiviation à l'aide d'une solution d'acide, du silicium brut ayant une teneur en silicium supérieure à 95% en poids pour la fabrication de piles solaires, procédé caractérisé en ce qu'on fait précéder ou suivre une étape de purification chimique connue d'une évaporation sous vide entre 1500 et 1700° C sous une pression de $10^{-6}$ à $10^{-4}$ bar.

2. Procédé selon la revendication 1, caractérisé en ce qu'on broie jusqu'à une grosseur de grains de 20 à 60 μm le silicium brut à purifier.

3. Procédé selon une ou plusieurs des revendications 1 et 2, caractérisé en ce qu'on utilise comme solution d'acide un mélange d'acide chlorhydrique aqueux et d'acide fluorhydrique aqueux.

4. Procédé selon une ou plusieurs des revendications 1 à 3, caractérisé en ce qu'on ajoute, par kilogramme de silicium, 1 à 10 litres de solution d'acide.

5. Procédé selon une ou plusieurs des revendications 1 à 4, caractérisé en ce qu'on soumet en outre à une solidification dirigée le silicium brut à purifier.

6. Procédé selon la revendication 5, caractérisé en ce que la solidification dirigée est réalisé par retrait, à une vitesse de 20 à 40 mm/h, du creuset de masse fondue, de la zone chauffage.

7. Procédé selon une ou plusieurs des revendications 1 à 6, caractérisé en ce qu'on fait fondre tout d'abord du silicium brut ayant une haute teneur en bore et on le met en contact avec une masse fondue à rôle d'extraction.

8. Procédé selon la revendication 7, caractérisé en ce qu'on utilise comme masse à rôle d'extraction une masse fondue constituée d'un mélange de fluorure de calcium et de silicate de calcium.